(19) Europäisches Patentamt
European Patent Office
Office européen des brevets

(11) **EP 3 708 963 B1**

(12) **FASCICULE DE BREVET EUROPEEN**

(45) Date de publication et mention de la délivrance du brevet:
**28.06.2023 Bulletin 2023/26**

(21) Numéro de dépôt: **20162811.2**

(22) Date de dépôt: **12.03.2020**

(51) Classification Internationale des Brevets (IPC):
***G01D 5/14*** *(2006.01)*

(52) Classification Coopérative des Brevets (CPC):
**G01D 5/145;** G01D 5/24438; G01D 5/2451

(54) **SYSTÈME DE DÉTERMINATION D'AU MOINS UN PARAMÈTRE DE ROTATION D'UN ORGANE TOURNANT**

SYSTEM ZUR BESTIMMUNG MINDESTENS EINES PARAMETERS DER ROTATION EINES ROTATIONSORGANS

SYSTEM FOR DETERMINING AT LEAST ONE ROTATION PARAMETER OF A ROTATING MEMBER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.03.2019 FR 1902522**

(43) Date de publication de la demande:
**16.09.2020 Bulletin 2020/38**

(73) Titulaire: **NTN-SNR ROULEMENTS 74000 Annecy (FR)**

(72) Inventeurs:
• **DURET, Christophe 74290 Bluffy (FR)**
• **FLAMMIER, Cécile 74000 Annecy (FR)**
• **VANDAMME, Etienne 74540 Alleves (FR)**

(74) Mandataire: **Sayettat, Julien Christian Strato-IP 63, Boulevard de Ménilmontant 75011 Paris (FR)**

(56) Documents cités:
**EP-A1- 2 163 851      EP-A2- 1 202 025
JP-A- H02 307 011      JP-A- 2003 097 971**

EP 3 708 963 B1

**Description**

L'invention concerne un système de détermination d'au moins un paramètre de rotation d'un organe tournant, ledit système comprenant un codeur émettant un champ magnétique périodique ainsi qu'un capteur apte à détecter ledit champ magnétique.

Dans de nombreuses applications, on souhaite connaître en temps réel et avec une qualité optimale au moins un paramètre de rotation d'un organe tournant, tel que sa position, sa vitesse, son accélération ou son sens de déplacement.

Pour ce faire, les documents WO-2006/064169, JP-2003/097971 et JP-H02/307011 proposent l'utilisation d'un codeur destiné à être solidaire de l'organe mobile et sur lequel est formée une piste magnétique qui est apte à émettre un champ magnétique pseudo-sinusoïdal à distance de lecture d'un capteur comprenant plusieurs éléments sensibles.

De façon avantageuse, chaque élément sensible peut comprendre au moins un motif à base d'un matériau magnétorésistif à effet tunnel (TMR en anglais pour Tunnel Magnéto Résistance) dont la résistance varie en fonction du champ magnétique détecté, tel que par exemple décrit dans le document WO-2004/083881.

Pour déterminer un paramètre de déplacement de l'organe mobile en fonction de l'évolution du champ magnétique détecté, le document WO-2006/064169 prévoit une combinaison des signaux représentatifs de la résistance de chacun des éléments sensibles afin de délivrer deux signaux en quadrature et de même amplitude qui peuvent être utilisés pour calculer ledit paramètre.

Le document WO-2018/051011 propose un système de détermination dans lequel la piste du codeur présente une alternance de pôles magnétiques Nord et Sud séparés par des transitions s'étendant chacune suivant une spirale d'Archimède. En relation avec une lecture axiale du champ magnétique délivré par le codeur, cette réalisation permet de dissocier le nombre de pôles magnétiques, la largeur de ceux-ci et le diamètre du codeur. Il est ainsi possible d'avoir peu de pôles tout en gardant des signaux magnétiques de bonne sinusoïdalité.

Par ailleurs, certaines applications nécessitent une lecture radiale du champ magnétique délivré par le codeur, notamment du fait des contraintes d'encombrement disponible. Pour ce faire, on connaît des codeurs comprenant un corps présentant une périphérie cylindrique sur laquelle la piste magnétique est formée, ladite piste présentant des transitions magnétiques alignées avec l'axe de rotation.

Dans cette réalisation, la largeur des pôles est le rapport de la circonférence sur le nombre de pôles, ce qui pose problème avec des codeurs au faible nombre de paires de pôles, typiquement inférieur à 6, puisque la largeur polaire devient importante, notamment de l'ordre de la dizaine de millimètres.

Ces pôles larges délivrent un signal magnétique dont la sinusoïdalité est mauvaise à faible entrefer de lecture, en devenant riche en harmoniques impaires, impropres à une mesure précise de l'angle, nécessitant un éloignement des éléments sensibles de la piste magnétique, ce qui va à l'encontre de l'amplitude dudit signal et donc de sa bonne détection par les éléments sensibles.

De plus, des pôles larges nécessitent une épaisseur du codeur elle-aussi plus importante afin de préserver une sinusoïdalité et une amplitude suffisantes pour le signal magnétique. Ceci n'est pas favorable à l'intégration du codeur dans des dimensions réduites et complexifie le procédé d'aimantation, car une plus grande épaisseur de matériau doit être saturée magnétiquement.

L'invention vise à perfectionner l'art antérieur en proposant notamment un système de détermination à lecture radiale du champ magnétique délivré par un codeur, dans lequel le compromis entre la périodicité et l'amplitude du champ magnétique détecté peut être satisfait sans induire de contrainte d'encombrement spécifique pour le codeur, et ce en particulier en relation avec un codeur magnétique à faible nombre de paires de pôles.

En particulier, le codeur à lecture radiale suivant l'invention est tel que la largeur polaire de chacun des pôles est indépendante du nombre de paires de pôles, pouvant ainsi concilier un faible nombre de paires de pôles avec un positionnement adéquat des éléments sensibles relativement à la sinusoïdalité et à l'amplitude du champ magnétique à détecter.

A cet effet, l'invention propose un système de détermination d'au moins un paramètre de rotation d'un organe tournant, ledit système comprenant :

- un codeur destiné à être associé en rotation à l'organe tournant de sorte à se déplacer conjointement avec lui, ledit codeur comprenant un corps présentant une périphérie cylindrique de rayon a autour d'un axe de révolution, ladite périphérie présentant une alternance de pôles magnétiques Nord et Sud de largeur l qui sont séparés par des transitions, chacune desdites transitions s'étendant suivant une hélice de pas p et d'angle $\alpha$ afin de former une piste magnétique multipolaire qui est apte à émettre un champ magnétique périodique représentatif de la rotation dudit codeur, ladite piste présentant $N_{pp}$ paires de pôles Nord et Sud et une largeur polaire $L_p$ mesurée le long d'une normale aux transitions qui sont tels que : $N_{pp} = \pi a/l$ et $L_p = p.\cos\alpha$ ;
- un capteur apte à détecter le champ magnétique périodique émis par ledit codeur au moyen d'au moins deux éléments sensibles magnétiques qui sont disposés à distance de lecture radiale de la piste magnétique, lesdits éléments sensibles étant disposés l'un par rapport à l'autre de sorte à délivrer des signaux en quadrature ;

le capteur comprenant au moins deux groupes de deux éléments sensibles, le barycentre des éléments sensibles d'un groupe étant espacé du barycentre des éléments sensibles de l'autre groupe d'une distance d mesurée le long de la normale aux transitions qui est égale à Lp/2 modulo Lp.

D'autres particularités et avantages de l'invention apparaîtront dans la description qui suit, faite en référence aux figures jointes, dans lesquelles :

- les figures 1a et 1b représentent de façon schématique un codeur d'un système de détermination selon l'invention, respectivement en perspective (figure 1a) et en vue de côté (figure 1b) ;
- la figure 2 est une représentation à plat de la périphérie cylindrique du codeur des figures 1a et 1b ;
- les figures 3a et 3b représentent de façon schématique respectivement une variante d'une réalisation de la disposition à distance de lecture radiale des éléments sensibles par rapport à un codeur, ces variantes ne relevant pas de l'invention et n'étant présentées qu'à titre indicatif ;
- les figures 4a et 4b représentent de façon schématique respectivement une variante d'une réalisation de la disposition à distance de lecture radiale des éléments sensibles par groupe par rapport à un codeur suivant l'invention ;
- les figures 5a, 5b et 5c représentent de façon schématique respectivement une variante d'une réalisation de la disposition à distance de lecture radiale des éléments sensibles par groupe par rapport à un codeur suivant l'invention ;
- la figure 6 est une courbe montrant le filtrage de l'harmonique de rang 3 en fonction de la distance entre les éléments sensibles d'un groupe.

En relation avec ces figures, on décrit un système de détermination d'au moins un paramètre de rotation d'un organe tournant par rapport à une structure fixe. En particulier, le paramètre de l'organe tournant peut être choisi parmi sa position, sa vitesse, son sens de rotation, son accélération ou son sens de déplacement, notamment axial.

Dans une application particulière, le système peut être utilisé en relation avec le pilotage d'un moteur électrique à courant continu sans balai, permettant notamment de connaître la position angulaire absolue sur une paire de pôles moteur du rotor par rapport au stator.

Le système de détermination comprend un codeur 1 destiné à être solidaire de l'organe tournant de sorte à se déplacer conjointement avec lui, ledit codeur comprenant un corps présentant une périphérie cylindrique de rayon a autour d'un axe de révolution X sur laquelle est formée une piste magnétique 2 qui est apte à émettre un champ magnétique périodique représentatif de la rotation dudit codeur. En particulier, le champ magnétique émis peut être sinusoïdal ou pseudo-sinusoïdal, c'est-à-dire présentant au moins une portion qui peut être approximée correctement par une sinusoïde.

La piste 2 présente une alternance de pôles magnétiques Nord 2n et Sud 2s de largeur l qui sont séparés par des transitions 3, chacune desdites transitions s'étendant suivant une hélice de pas p et d'angle $\alpha$.

Ainsi, la piste magnétique présente $N_{pp}$ paires de pôles Nord et Sud et une largeur polaire $L_p$ mesurée le long d'une normale N aux transitions 3 qui sont tels que : $N_{pp} = \pi a/l$ et $L_p = p.cos\alpha$. La piste magnétique 2 délivre un signal magnétique pseudo-sinusoïdal dont la période spatiale selon la normale N est égale à $\lambda = 2.L_p$.

En particulier, le champ magnétique généré par le codeur 1 sur une paire de pôles magnétiques 2n, 2s est la combinaison d'une composante fondamentale, sinusoïdale parfaite que l'on souhaite mesurer pour déterminer le paramètre, et de plusieurs harmoniques de rang impair (3, 5, etc...).

Si l'on suppose que le codeur 1 tourne à une vitesse de rotation constante $\omega$, le champ magnétique peut être écrit de la façon suivante :

$$H(t) = H_1.sin\omega t + H_3.sin3\omega t + H_5.sin5\omega t + \ ...$$

L'amplitude Hs de l'harmonique de rang 3 peut représenter typiquement 5% de l'amplitude $H_1$ de la fondamentale. Selon la position du capteur et la distance de lecture, cette proportion de l'amplitude $H_3$ de l'harmonique de rang 3 peut être très supérieure.

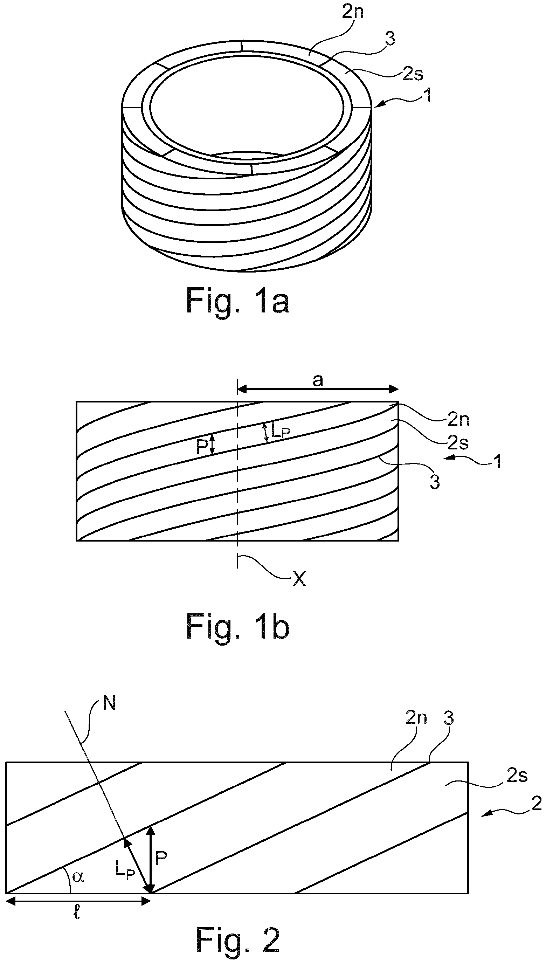

La géométrie en hélice de la piste magnétique 2 permet notamment que le nombre $N_{pp}$ de paires de pôles 2n, 2s ainsi que la largeur polaire $L_p$ puissent être choisis indépendamment du rayon a de la piste magnétique 2. En relation avec les figures 1a et 1b, le codeur 1 comprend quatre paires de pôles 2n, 2s, ce qui est particulièrement adapté pour le pilotage d'un moteur électrique à quatre paires de pôles, le système fournissant la position absolue sur une paire de pôles moteur, soit 90° mécanique.

Selon une réalisation, le codeur 1 est formé d'un aimant sur la périphérie cylindrique duquel la piste magnétique multipolaire 2 est réalisée. En particulier, l'aimant peut être formé d'une matrice annulaire, par exemple réalisée à base d'un matériau plastique ou élastomère, dans laquelle sont dispersées des particules magnétiques, notamment des particules de ferrite ou de terres rares comme le NdFeB.

Le système de détermination comprend un capteur qui est destiné à être solidaire de la structure fixe, ledit capteur étant apte à détecter le champ magnétique périodique émis par le codeur 1. Pour ce faire, le capteur comprend au moins deux éléments sensibles magnétiques 4, 5 qui sont disposés à distance de lecture radiale de la piste magnétique 2 pour délivrer chacun un signal représentatif de la rotation du codeur 1, lesdits éléments sensibles étant disposés l'un par rapport à l'autre de sorte à délivrer des signaux en quadrature.

Chacun des éléments sensibles 4, 5 peut notamment être choisi parmi les sondes magnétosensibles. Par exemple, des sondes à base d'effet Hall, de magnétorésistances à effet tunnel (TMR), de magnétorésistances anisotropes (AMR) ou de magnétorésistances géantes (GMR) peuvent mesurer chacune des deux composantes du champ magnétique (normale et tangentielle au codeur 1).

En particulier, comme décrit dans le document WO-2004/083881, chaque élément 4, 5 forme une jonction tunnel en comprenant un empilement d'une couche magnétique de référence, d'une couche de séparation isolante et d'une couche magnétique sensible au champ à détecter, la résistance de l'empilement étant fonction de l'orientation relative de l'aimantation des couches magnétiques.

De manière avantageuse, chaque élément sensible 4, 5 peut comprendre au moins un motif à base d'un matériau magnétorésistif, notamment à effet tunnel, dont la résistance varie en fonction du champ magnétique, un élément sensible 4, 5 pouvant comprendre un seul motif ou un groupe de motifs reliés en série ou en parallèle.

En variante, la composante normale seule du champ magnétique délivré par le codeur 1 peut être mesurée, par exemple grâce à des éléments à effet Hall. L'utilisation du champ normal seul est favorable car il est plus sinusoïdal que le champ tangentiel.

Pour pouvoir déterminer le paramètre de rotation de l'organe tournant, les signaux délivrés par les éléments sensibles 4, 5 doivent être préférentiellement en quadrature, c'est-à-dire déphasés géométriquement de 90° divisé par $N_{pp}$. En particulier, par exploitation de tels signaux en quadrature, dans le capteur ou dans un calculateur associé, il est connu de déterminer la position angulaire du codeur 1, par exemple par un calcul direct d'une fonction arctangente, à l'aide d'une « Look-Up Table » (LUT) ou grâce à une méthode de type CORDIC.

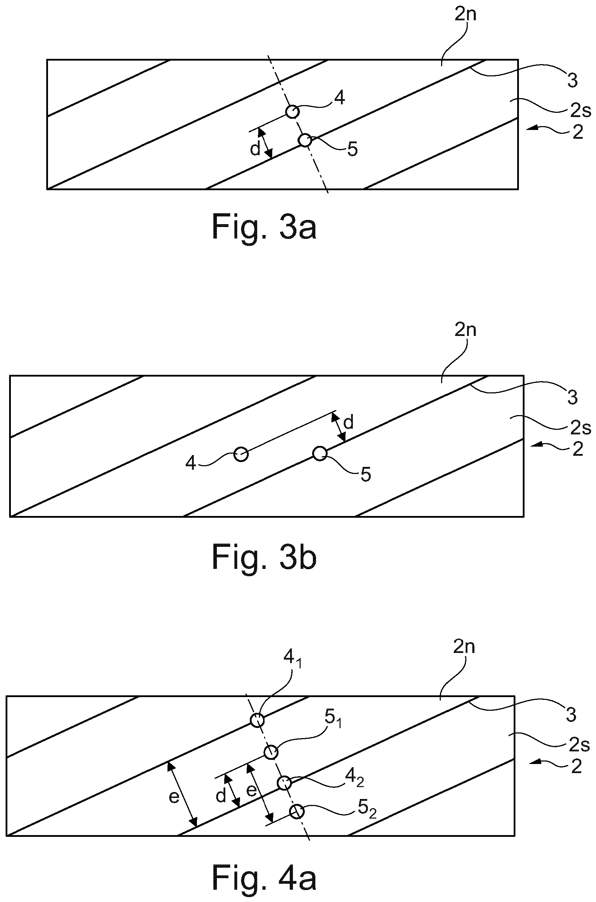

Pour ce faire, en relation avec les figures 3a et 3b, on décrit à titre indicatif une variante qui ne relève pas de l'invention, dans laquelle le capteur comprend au moins deux éléments sensibles 4, 5 qui sont espacés d'une distance d mesurée le long de la normale N aux transitions 3 qui est égale à $L_p/2$ modulo $L_p$. En d'autres termes, lorsqu'un élément sensible 4 est positionné en regard d'une transition 3, l'autre élément sensible 5 est positionné sur une hélice parallèle à ladite transition et espacée d'elle d'une distance d mesurée le long de la normale N.

Ainsi, on obtient un bon compromis entre sinusoïdalité et amplitude du signal détecté. En particulier, ce positionnement optimal peut être obtenu avec une largeur polaire $L_p$ comprise entre 2 et 6 mm, et ce même avec un nombre $N_{pp}$ de paires de pôles 2n, 2s du codeur 1 qui est inférieur à 6.

En relation avec une application du système au pilotage d'un moteur électrique, la bonne sinusoïdalité du signal délivré au calculateur de pilotage permet notamment :

- de meilleures performances, notamment au démarrage, par exemple le temps pour atteindre la consigne de vitesse ou de position ;
- un fonctionnement plus « doux », sans saut de couple en régime établi ;
- une plus faible consommation d'énergie ;
- une température de fonctionnement inférieure ;
- un couple maximum plus important.

En particulier, la figure 3a représente deux éléments sensibles 4, 5 qui sont alignés le long de la normale N aux transitions 3, lesdits éléments étant alignés circonférentiellement sur la figure 3b, notamment en position médiane de la périphérie du codeur 1 pour être éloignés au maximum des bords dudit codeur. En variante, les deux éléments sensibles 4, 5 peuvent être alignés le long de l'axe de révolution X.

Selon l'invention, en relation avec les figures 4a à 5c, le capteur comprend au moins deux groupes de deux éléments sensibles $4_1$, $4_2$ ; $5_1$, $5_2$, le barycentre des éléments sensibles $4_1$, $4_2$ ; $5_1$, $5_2$ d'un groupe étant espacé du barycentre des éléments sensibles $4_1$, $4_2$ ; $5_1$, $5_2$ de l'autre groupe d'une distance d mesurée le long de la normale N aux transitions 3 qui est égale à $L_p/2$ modulo $L_p$.

Ainsi, en relation avec un tel dédoublement des éléments sensibles 4, 5 de la réalisation des figures 3a et 3b, les deux groupes permettent un filtrage du bruit venant de l'extérieur (par exemple du moteur ou des interconnexions voisines).

En effet, en prévoyant que le capteur comprenne en outre un dispositif de soustraction des signaux ($V_1$, $V_2$) délivrés par les deux éléments sensibles $4_1$, $4_2$ ; $5_1$, $5_2$ de chacun des groupes, si le champ magnétique comporte une composante de bruit identique sur les différents éléments sensibles $4_1$, $4_2$ ; $5_1$, $5_2$, celle-ci sera soustraite du signal de sortie.

En positionnant les éléments sensibles $4_1$, $4_2$ ; $5_1$, $5_2$ d'un groupe aux phases magnétiques respectivement $\varphi_1$ et $\varphi_2$, c'est-à-dire en les espaçant d'une distance e mesurée le long de la normale N aux transitions 3 qui est telle que $\varphi_1 - \varphi_2 = \dfrac{e}{2L_p} * 360$ , les signaux $V_1$, $V_2$ délivrés par chacun desdits éléments sensibles $4_1$, $4_2$ ; $5_1$, $5_2$ peuvent s'écrire :

$$V_1(t) = G.H_1.\sin(\omega t + \varphi_1) + G.H_3.\sin(3\omega t + 3\varphi_1) + G.H_5.\sin(5\omega t + 5\varphi_1) + \ldots$$

$$V_2(t) = G.H_1.\sin(\omega t + \varphi_2) + G.H_3.\sin(3\omega t + 3\varphi_2) + G.H_5.\sin(5\omega t + 5\varphi_2) + \ldots$$

G étant le gain supposé identique des éléments sensibles $4_1$, $4_2$ ; $5_1$, $5_2$, $\omega$ étant la vitesse de rotation, $H_i$ étant l'amplitude de la fondamentale pour i=1 et des harmoniques de rang i pour i=3, 5, etc.

Un circuit soustracteur effectue la différence qui s'écrit alors :

$$\begin{aligned}V_1(t) - V_2(t) = {} & G.H_1.[\sin(\omega t + \varphi_1) - \sin(\omega t + \varphi_2)] \\ & + G.H_3.[\sin(3\omega t + 3\varphi_1) - \sin(3\omega t + 3\varphi_2)] \\ & + G.H_5.[\sin(5\omega t + 5\varphi_1) - \sin(5\omega t + 5\varphi_2)] + \ldots \\ = {} & 2.G.H_1.\sin\left(\frac{\varphi_1 - \varphi_2}{2}\right).\cos\left(\omega t + \frac{\varphi_1 + \varphi_2}{2}\right) \\ & + 2.G.H_3.\sin\left(3.\frac{\varphi_1 - \varphi_2}{2}\right).\cos\left(3\omega t + 3.\frac{\varphi_1 + \varphi_2}{2}\right) \\ & + 2.G.H_5.\sin\left(5.\frac{\varphi_1 - \varphi_2}{2}\right).\cos\left(5\omega t + 5.\frac{\varphi_1 + \varphi_2}{2}\right) \\ & + \cdots \end{aligned}$$

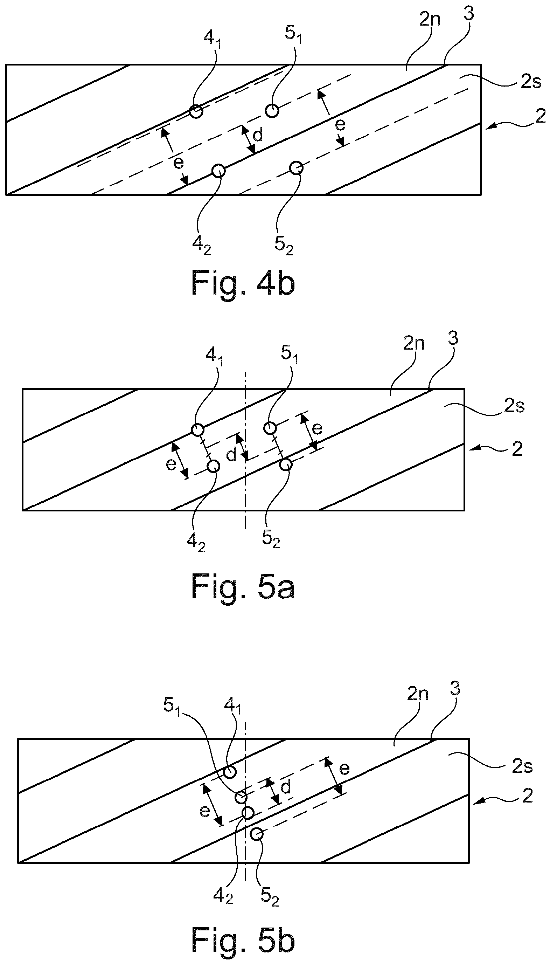

En relation avec les figures 4a et 4b, e = $L_p$ modulo $2L_p$, c'est-à-dire que les éléments sensibles $4_1$, $4_2$ ; $5_1$, $5_2$ d'un groupe sont déphasés de 180° modulo 360°, cette différence s'écrit :

$$\begin{aligned}V_1(t) - V_2(t) = {} & 2.G.H_1 cos\left(\omega t + \frac{\varphi_1 + \varphi_2}{2}\right) - 2.G.H_3.cos\left(3\omega t + 3.\frac{\varphi_1 + \varphi_2}{2}\right) \\ & + 2.G.H_5.cos\left(5\omega t + 5.\frac{\varphi_1 + \varphi_2}{2}\right) + \cdots \end{aligned}$$

On voit que les harmoniques 3 et 5 sont conservées et ont le même gain 2 que la fondamentale après l'opération de soustraction.

Pour obtenir une détermination précise du paramètre de rotation, on souhaite mesurer le signal filtré d'au moins l'harmonique de rang 3. Toutefois, toute compensation fixe de l'erreur apportée par les harmoniques est difficile à réaliser, notamment en ce qu'elle dépend des conditions de mesure (entrefer, position du capteur). Par ailleurs, une calibration est également difficilement envisageable pour une application en grand volume et bas coût.

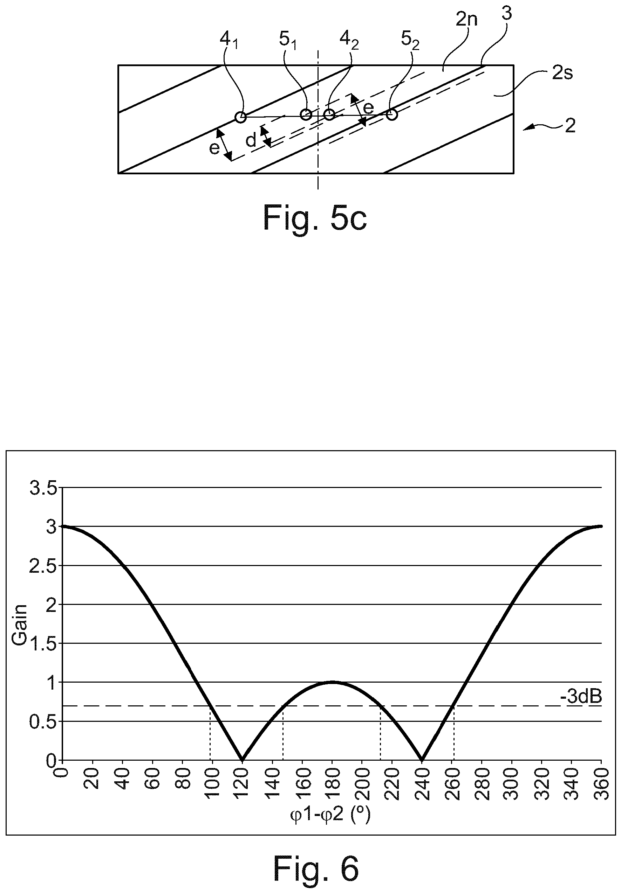

La figure 6 illustre le filtrage de l'harmonique de rang 3 en fonction de la valeur du déphasage $\varphi_1 - \varphi_2$.

En relation avec les figures 5a à 5c dans lesquelles la distance e est sensiblement égale à $2/3L_p$ ou $4/3L_p$ modulo $2L_p$, la différence s'écrit :

$$V_1(t) - V_2(t) = \sqrt{3}.G.H_1\cos\left(\omega t + \frac{\varphi_1 + \varphi_2}{2}\right) + 0$$

$$- \sqrt{3}.G.H_5.\cos\left(5\omega t + 5.\frac{\varphi_1 + \varphi_2}{2}\right) + \cdots$$

Dans ce cas, l'harmonique 3 est annulée, la fondamentale et l'harmonique 5 ont un gain de 1,73 après l'opération de soustraction. On a donc réalisé un filtre spatial de l'harmonique 3, tout en conservant 86,5% de la fondamentale.

De façon générale et en relation avec la figure 6, en considérant que le filtre de l'harmonique de rang 3 joue son rôle s'il enlève au moins 3 dB à sa valeur sans filtrage par rapport à l'amplitude de la fondamentale, il faut donc que :

$$\left|\frac{2.G.H_3.\sin\left(3\frac{\varphi_1 - \varphi_2}{2}\right)}{2.G.H_1.\sin\left(\frac{\varphi_1 - \varphi_2}{2}\right)}\right| \leq \frac{\sqrt{2}}{2}.\left|\frac{H_3}{H_1}\right|$$

$$\Leftrightarrow \left|\frac{\sin\left(3\frac{\varphi_1 - \varphi_2}{2}\right)}{\sin\left(\frac{\varphi_1 - \varphi_2}{2}\right)}\right| \leq \frac{\sqrt{2}}{2}$$

$$\Leftrightarrow \varphi_1 - \varphi_2 \in [99° ; 148°] \text{ modulo } 360°$$

$$\text{ou } \varphi_1 - \varphi_2 \in [212° ; 261°] \text{ modulo } 360°$$

Exprimé en distance, pour obtenir un filtrage de l'harmonique 3, il faut donc que les éléments sensibles $4_1$, $4_2$ ; $5_1$, $5_2$ d'un groupe soient espacés d'une distance e mesurée le long de la normale N aux transitions 3 qui est telle que :

$$0{,}55L_p < e < 0{,}82L_p, \text{ modulo } 2L_p;$$

ou

$$1{,}18L_p < e < 1{,}45L_p, \text{ modulo } 2L_p.$$

En particulier, la distance e entre les éléments sensibles $4_1$, $4_2$ ; $5_1$, $5_2$ d'un groupe peut varier dans les plages mentionnées ci-dessus pour optimiser le couple filtrage - gain. Par ailleurs, en fonction de l'encombrement disponible, les éléments sensibles $4_1$, $4_2$ ; $5_1$, $5_2$ des groupes peuvent être alignés le long de la normale N aux transitions 3 (figures 4a et 5b) ou circonférentiellement (figure 5c). En variante, les éléments sensibles $4_1$, $4_2$ ; $5_1$, $5_2$ d'un groupe peuvent être décalés circonférentiellement par rapport à ceux de l'autre groupe (figure 4b et 5a).

La suppression, ou au moins l'atténuation, de l'harmonique de rang 3 dans les signaux traités pour déterminer le paramètre de rotation est bénéfique relativement à la précision de ladite détermination, mais également pour les algorithmes de traitement du signal qui réalisent :

- la suppression de l'offset desdits signaux ;
- l'égalisation des amplitudes desdits signaux ;
- la correction de phase entre lesdits signaux.

## Revendications

1. Système de détermination d'au moins un paramètre de rotation d'un organe tournant, ledit système comprenant :

   - un codeur (1) destiné à être associé en rotation à l'organe tournant de sorte à se déplacer conjointement avec lui, ledit codeur comprenant un corps présentant une périphérie cylindrique de rayon a autour d'un axe de révolution (X), ladite périphérie présentant une alternance de pôles magnétiques Nord (2n) et Sud (2s) de largeur l qui sont séparés par des transitions (3), chacune desdites transitions s'étendant suivant une hélice de pas p et d'angle $\alpha$ afin de former une piste magnétique (2) multipolaire qui est apte à émettre un champ magnétique périodique représentatif de la rotation dudit codeur, ladite piste présentant $N_{PP}$ paires de pôles Nord (2n) et Sud (2s) et une largeur polaire $L_p$ mesurée le long d'une normale (N) aux transitions (3) qui sont tels que : $N_{pp} = \pi a/l$ et $L_p = p.\cos\alpha$ ;

- un capteur apte à détecter le champ magnétique périodique émis par ledit codeur au moyen d'au moins deux éléments sensibles magnétiques $(4, 5 ; 4_1, 4_2 ; 5_1, 5_2)$ qui sont disposés à distance de lecture radiale de la piste magnétique (2), lesdits éléments sensibles étant disposés l'un par rapport à l'autre de sorte à délivrer des signaux en quadrature ;

ledit système étant **caractérisé en ce que** le capteur comprend au moins deux groupes de deux éléments sensibles $(4_1, 4_2 ; 5_1, 5_2)$, le barycentre des éléments sensibles $(4_1, 4_2 ; 5_1, 5_2)$ d'un groupe étant espacé du barycentre des éléments sensibles $(5_1, 5_2 ; 4_1, 4_2)$ de l'autre groupe d'une distance d mesurée le long de la normale (N) aux transitions (3) qui est égale à $L_p/2$ modulo $L_p$.

2. Système de détermination selon la revendication 1, **caractérisé en ce que** le capteur comprend en outre un dispositif de soustraction des signaux $(V_1, V_2)$ délivrés par les deux éléments sensibles $(4_1, 4_2 ; 5_1, 5_2)$ de chacun des groupes.

3. Système de détermination selon l'une des revendications 1 ou 2, **caractérisé en ce que** les éléments sensibles $(4_1, 4_2 ; 5_1, 5_2)$ d'un groupe sont espacés d'une distance e mesurée le long de la normale (N) aux transitions (3) qui est telle que : $e = L_p$ modulo $2L_p$.

4. Système de détermination selon l'une des revendications 1 ou 2, **caractérisé en ce que** les éléments sensibles $(4_1, 4_2 ; 5_1, 5_2)$ d'un groupe sont espacés d'une distance e mesurée le long de la normale (N) aux transitions (3) qui est telle que :

$$0,55L_p < e < 0,82L_p, \text{ modulo } 2L_p;$$

ou

$$1,18L_p < e < 1,45L_p, \text{ modulo } 2L_p.$$

5. Système de détermination selon la revendication 4, **caractérisé en ce que** la distance e est sensiblement égale à $2/3L_p$ ou $4/3L_p$ modulo $2L_p$.

6. Système de détermination selon l'une quelconque des revendications 1 à 5, **caractérisé en ce que** les éléments sensibles $(4_1, 4_2 ; 5_1, 5_2)$ sont alignés.

**Patentansprüche**

1. System zur Bestimmung mindestens eines Rotationsparameters eines sich drehenden Elements, wobei das System Folgendes umfasst:

- einen Codierer (1), der dazu bestimmt ist, in der Drehung dem sich drehenden Element zugeordnet zu werden, so dass er sich zusammen mit diesem bewegt, wobei der Codierer einen Körper umfasst, der einen zylindrischen Umfang mit einem Radius a um eine Rotationsachse (X) aufweist, wobei der Umfang einen Wechsel von magnetischen Nordpolen (2n) und Südpolen (2s) mit der Breite I aufweist, die durch Übergänge (3) getrennt sind, wobei sich jeder der Übergänge entlang einer Helix aus der Steigung p und dem Winkel $\alpha$ erstreckt, um eine multipolare Magnetspur (2) zu bilden, die dazu fähig ist, ein periodisches Magnetfeld auszusenden, das die Rotation des Codierers darstellt, wobei die Spur $N_{pp}$ Paare von Nordpolen (2n) und Südpolen (2s) und eine polare Breite $L_p$ aufweist, die entlang einer Normalen (N) zu den Übergängen (3) gemessen wird, die wie folgt sind: $N_{pp} = \pi a/l$ und $L_p = p.\cos\alpha$;

- einen Sensor, der dazu fähig ist, das von dem Codierer ausgesendete periodische Magnetfeld mittels mindestens zwei magnetempfindlichen Elementen $(4, 5; 4_1, 4_2; 5_1, 5_2)$, die in einem radialen Leseabstand von der Magnetspur (2) angeordnet sind, zu detektieren, wobei die empfindlichen Elemente im Bezug zueinander so angeordnet sind, dass sie Quadratursignale liefern;

wobei das System **dadurch gekennzeichnet ist, dass** der Sensor mindestens zwei Gruppen von zwei empfindlichen Elementen ($4_1$, $4_2$; $5_1$, $5_2$) umfasst, wobei der Schwerpunkt der empfindlichen Elemente ($4_1$, $4_2$; $5_1$, $5_2$) einer Gruppe von dem Schwerpunkt der empfindlichen Elemente ($5_1$, $5_2$; $4_1$, $4_2$) der anderen Gruppe um einen Abstand d beabstandet ist, der entlang der Normalen (N) zu den Übergängen (3) gemessen wird und gleich $L_p/2$ Modulo $L_p$ ist.

2. Bestimmungssystem nach Anspruch 1, **dadurch gekennzeichnet, dass** der Sensor ferner eine Vorrichtung zum Subtrahieren der von den beiden empfindlichen Elementen ($4_1$, $4_2$; $5_1$, $5_2$) jeder der Gruppen gelieferten Signale ($V_1$, $V_2$) umfasst.

3. Bestimmungssystem nach einem der Ansprüche 1 oder 2, **dadurch gekennzeichnet, dass** die empfindlichen Elemente ($4_1$, $4_2$; $5_1$, $5_2$) einer Gruppe um einen Abstand e beabstandet sind, der entlang der Normalen (N) zu den Übergängen (3) gemessen wird und wie folgt ist: $e = L_p$ Modulo $2L_p$.

4. Bestimmungssystem nach einem der Ansprüche 1 oder 2, **dadurch gekennzeichnet, dass** die empfindlichen Elemente ($4_1$, $4_2$; $5_1$, $5_2$) einer Gruppe um einen Abstand e beabstandet sind, der entlang der Normalen (N) zu Übergängen (3) gemessen wird und wie folgt ist:

$$0,55L_p < e < 0,82L_p, \text{ Modulo } 2L_p;$$

oder

$$1,18L_p < e < 1,45L_p, \text{ Modulo } 2L_p.$$

5. Bestimmungssystem nach Anspruch 4, **dadurch gekennzeichnet, dass** der Abstand e im Wesentlichen gleich $2/3L_p$ oder $4/3L_p$ Modulo $2L_p$ ist.

6. Bestimmungssystem nach einem der Ansprüche 1 bis 5, **dadurch gekennzeichnet, dass** die empfindlichen Elemente ($4_1$, $4_2$; $5_1$, $5_2$) ausgerichtet sind.

**Claims**

1. System for determining at least one rotation parameter of a rotating member, said system comprising:

   - a coder (1) intended to be associated rotationally with the rotating member in such a way as to move jointly with it, said coder comprising a body having a cylindrical periphery with a radius a around an axis of revolution (X), said periphery having an alternation of North (2n) and South (2s) magnetic poles of width l which are separated by transitions (3), each one of said transitions extending along an helix of pitch p and of angle $\alpha$ so as to form a multipolar magnetic track (2) which is able to emit a periodic magnetic field representative of the rotation of said coder, said track having $N_{pp}$ pairs of North (2n) and South (2s) poles and a polar width $L_p$ measured along a normal (N) to the transitions (3) which are such that: $N_{pp} = \pi a/l$ and $L_p = p.\cos\alpha$;
   - a sensor able to detect the period magnetic field emitted by said coder by means of at least two sensitive magnetic elements (4, 5; $4_1$, $4_2$; $5_1$, $5_2$) which are disposed at a radial reading distance from the magnetic track (2), said sensitive elements being disposed in relation to one another so as to deliver signals in quadrature ;

   said system being **characterised in that** the sensor comprises at least two groups of two sensitive elements ($4_1$, $4_2$; $5_1$, $5_2$), the barycentre of the sensitive elements ($4_1$, $4_2$; $5_1$, $5_2$) of one group being separated from the barycentre of the sensitive elements ($5_1$, $5_2$; $4_1$, $4_2$) of the other group by a distance d measured along the normal (N) to the transitions (3) which is equal to $L_p/2$ modulo $L_p$.

2. System for determining according to claim 1, **characterised in that** the sensor further comprises a device for subtracting signals ($V_1$, $V_2$) delivered by the two sensitive elements ($4_1$, $4_2$; $5_1$, $5_2$) of each one of the groups.

3. System for determining according to one of claims 1 or 2, **characterised in that** the sensitive elements ($4_1$, $4_2$; $5_1$,

$5_2$) of a group are spaced by a distance e measured along the normal (N) to the transitions (3) which is such that: $e = L_p$ modulo $2L_p$.

4. System for determining according to one of claims 1 or 2, **characterised in that** the sensitive elements ($4_1$, $4_2$; $5_1$, $5_2$) of a group are spaced by a distance e measured along the normal (N) to the transitions (3) which is such that:

$$0.55L_p < e < 0.82L_p, \text{ modulo } 2L_p;$$

or

$$1.18L_p < e < 1.45L_p, \text{ modulo } 2L_p.$$

5. System for determining according to claim 4, **characterised in that** the distance e is substantially equal to $2/3L_p$ or $4/3L_p$ modulo $2L_p$.

6. System for determining according to any of claims 1 to 5, **characterised in that** the sensitive elements ($4_1$, $4_2$; $5_1$, $5_2$) are aligned.

Fig. 1a

Fig. 1b

Fig. 2

Fig. 3a

Fig. 3b

Fig. 4a

Fig. 4b

Fig. 5a

Fig. 5b

Fig. 5c

Fig. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2006064169 A
- JP 2003097971 A
- JP H02307011 B
- WO 2004083881 A
- WO 2018051011 A